# FASCICULE DE BREVET EUROPEEN

(11) **EP 0 468 846 B1**
(45) Date de publication et mention de la délivrance du brevet: **27.03.1996**
(21) Numéro de dépôt: 91401932.8
(22) Date de dépôt: 10.07.1991
(51) Int. Cl.: H03K 5/08, H03G 11/00

(54) **Circuit d'écrêtage**
Spritzenwertbegrenzer
Clipping circuit

(30) Priorité: 23.07.1990 FR 9009364
(43) Date de publication de la demande: 29.01.1992
(73) Titulaire: BULL S.A., F-78430 Louveciennes (FR)
(72) Inventeur: Neu, Georges, F-75116 Paris (FR)
(74) Mandataire: Denis, Hervé

(56) Documents cités:
- GB-A- 2 015 839
- GB-A- 2 132 447
- RCA TECHNICAL NOTE, TN no. 877, 12 février 1971, pages 1-2, Princeton, NJ, US; H.F. KING: "Dynamic input clamp for integrated circuit gates"
- PATENT ABSTRACTS OF JAPAN, vol. 3, no. 135 (E-150)[47], 10 novembre 1979 & JP-A-54 112 156

## Description

L'invention concerne un circuit d'écrêtage utilisable notamment à l'entrée de circuits intégrés de type VLSI (Very Large Scale Integration).

Dans les transmissions entre circuits VLSI, les signaux sont affectés par des allers-retours sur la ligne de transmission, plus précisément par des suroscillations provoquées par les selfs des boîtiers des circuits VLSI.

Ces suroscillations présentent des amplitudes de plus en plus importantes avec l'augmentation actuelle de la fréquence utilisée dans les circuits intégrés. Les oscillations sont particulièrement nuisibles autour du niveau "bas", en particulier dans des circuits réalisés en technologie T2L où le seuil de déclenchement se situe à 1,4 volt.

Il est connu d'utiliser dans des circuits VLSI des diodes écrêtant une partie des oscillations parasites pour en réduire les effets. Toutefois cette solution ne donne pas entièrement satisfaction dans la mesure où les diodes courantes ne commencent à conduire qu'à partir d'une tension de seuil VBE de l'ordre de 0,8 volt. On utilise de préférence des diodes Schottky présentant une tension de seuil VBE de l'ordre de 0,4 volt. Cependant les procédés de fabrication des diodes Schottky sont coûteux et aujourd'hui quasiment incompatibles avec la technologie MOS (Métal-Oxyde-Silicium).

L'invention se rapporte plus particulièrement aux circuits intégrés fabriqués selon la technologie connue sous le nom de BiMOS et utilisant des transistors bipolaires et des transistors à effet de champ du type MOS, c'est-à-dire à grille isolée. Dans cette technologie, on connaît du document "Patent Abstract of Japan", vol. 3, n° 135, (E-150) (47) un circuit logique comprenant un transistor bipolaire et un transistor à effet de champ à grille isolée IGFET. Le transistor bipolaire a son émetteur à la masse, son collecteur connecté à la grille du transistor IGFET ainsi qu'à un second potentiel d'alimentation au travers d'une résistance de charge et sa base connectée au drain du transistor IGFET, dont la source reçoit le signal d'entrée. Cependant, ce circuit logique fonctionne de façon que le transistor bipolaire commute rapidement et n'a pas la fonction d'un circuit d'écrêtage.

L'invention a pour objet un circuit susceptible notamment d'absorber à la réception d'un signal pratiquement l'essentiel des suroscillations parasites à un des niveaux de travail ("bas"/"0" ou "haut"/"1") du signal.

A cet effet, l'invention propose un circuit d'écrêtage ayant les caractéristiques définies par la revendication 1.

Un tel circuit selon l'invention est particulièrement intéressant en ce qu'il est de structure simple, facile à réaliser notamment dans des circuits BiCMOS et compatible avec la technologie T2L.

Les caractéristiques et avantages de l'invention apparaîtront à la lecture de la description qui va suivre et qui se réfère aux dessins ci-annexés dans lesquels :
- la figure 1 représente l'allure générale d'un signal Vs apparaissant dans une ligne de transmission entre deux circuits VLSI non équipée du circuit d'écrêtage selon l'invention,
- la figure 2 représente un schéma du circuit d'écrêtage selon l'invention.

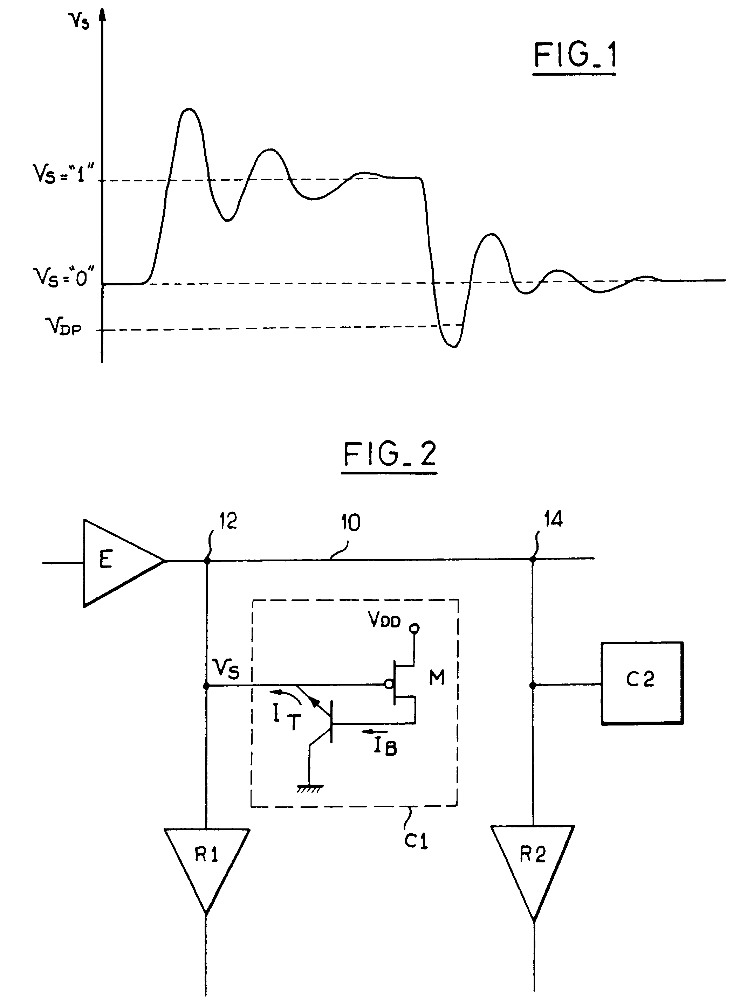

La figure 1 montre l'allure générale (schématique et volontairement déformée) d'un signal en tension Vs représentatif d'une impulsion rectangulaire dans une ligne de transmission reliant deux circuits intégrés du type VLSI non équipés de circuits d'écrêtage. On peut remarquer que chaque front de l'impulsion est suivi de suroscillations parasites dues aux selfs des boîtiers des VLSI, en particulier pour le front descendant de suroscillations caractéristiques de tensions "négatives" (dans la mesure où le niveau Vs = "0" est représentatif de la tension de référence zéro). Comme mentionné ci-dessus, l'écrêtage de l'oscillation "négative" réalisé à l'aide d'une diode passive (ligne VDP) n'est pas satisfaisant dans la mesure où la tension de seuil de cette diode (VBE voisin de 0,8 volt) décale par contruction la référence zéro du circuit de - 0,8 volt.

La figure 2 montre un dispositif émetteur E délivrant un signal Vs sur une ligne de transmission 10 pour être reçu par un ou plusieurs dispositifs récepteurs R1, R2 tels que, à titre d'exemple non limitatif, des amplificateurs tampons disposés en entrée dans des circuits intégrés de type VLSI, Chaque dispositif récepteur R1, R2 est connecté de façon indépendante par sa borne d'entrée 12, 14 à la ligne de transmission 10. Selon l'invention, chaque dispositif récepteur R1 (R2) est doté d'un circuit d'écrêtage C1 (C2), convenablement monté en dérivation à l'entrée 12 (14) dudit dispositif récepteur R1 (R2) et destiné, par exemple, à améliorer le niveau "bas" (ou niveau "0") du signal Vs à cette entrée 12 (14), en particulier à éliminer les tensions négatives parasites.

Le circuit d'écrêtage C1 se compose essentiellement d'un transistor d'écrêtage de type bipolaire T commandé à sa base par un transistor de charge M de type MOS dont la grille est connectée à l'entrée 12. Dans l'exemple illustré à la figure 2, le transistor M est du type PMOS dont la source est connectée à une tension d'entrée VDD et dont le drain est connecté à la base du transistor T. Ce transistor T du type n.p.n a son émetteur connecté à la borne d'entrée 12 et son collecteur connecté à la masse du circuit (tension de référence zéro). Dans la suite de l'exposé, Vs représente le niveau de tension présent à l'entrée 12 du circuit récepteur R1 et par voie de conséquence à la grille du transistor M et à l'émetteur du transistor T, I représente le courant circulant de l'émetteur du transistor T vers l'entrée 12 et IB représente le courant de base du transistor T.

Le circuit d'écrêtage C1 qui vient d'être décrit fonctionne de la façon suivante. Lorsque le signal Vs = "1", la tension positive présente à la grille du transistor M bloque ce transistor M. Le transistor T est également bloqué de telle sorte que le circuit C1 ne génère aucun courant I susceptible d'avoir un effet sur la tension instantanée Vs à l'entrée 12. Lorsque le signal Vs = "0", le transistor M est débloqué. Toutefois, aussi longtemps que la tension Vs à l'entrée 12 reste au niveau zéro, le courant IB reste très faible ainsi que le courant I (pratiquement limité au courant de fuite). Lorsque Vs devient "négatif" (c'est à dire inférieur au niveau zéro), en cas d'oscillations parasites à l'entrée 12, la variation de tension de grille du transistor M entraine un accroîssement du courant IB. Le transistor T est alors débloqué et produit un fort courant I. L'augmentation rapide du courant I issu du transistor T provoque à l'entrée 12 un retour brutal de Vs au niveau "0".

De façon pratique, l'invention est mise en oeuvre notamment en technologie BiCMOS dans des circuits VLSI incorporant, entre autres, les dispositifs récepteurs R1 et R2 et leurs circuits d'écrêtage.

L'invention n'est pas limitée au traitement des oscillations parasites autour du niveau "bas" du signal Vs mais s'applique également au niveau "haut". A cet effet, dans une variante non représentée du circuit d'écrêtage selon l'invention le transistor M est du type NMOS tandis que le transistor T du type p.n.p a sa base connectée à la borne drain du transistor M et son émetteur connecté à la borne d'entrée du dispositif récepteur.

## Revendications

1. Circuit d'écrêtage (C1) pour circuit intégré, monté en dérivation à l'entrée (12) d'un dispositif récepteur (R1), caractérisé en ce qu'il comprend un transistor d'écrêtage (T) de type bipolaire et un transistor de charge (M) de type MOS, avec l'émetteur du transistor d'écrêtage et la grille du transistor de charge connectés à ladite entrée (12), la base du transistor d'écrêtage connectée au drain du transistor de charge, le collecteur du transistor d'écrêtage connecté au potentiel relatif au niveau d'écrêtage et la source du transistor de charge connectée à un second potentiel d'alimentation.

2. Circuit selon la revendication 1, caractérisé en ce que le transistor d'écrêtage (T) est de type npn et le transistor de charge (M) est de type PMOS.

3. Circuit selon la revendication 1, caractérisé en ce que le transistor d'écrêtage (T) est de type pnp et le transistor de charge (M) est de type NMOS.

## Patentansprüche

1. Spitzenwertbegrenzungsschaltung (C1) für integrierte Schaltung, die zum Eingang (12) einer Empfängervorrichtung (R1) parallelgeschaltet ist, dadurch gekennzeichnet, daß sie einen Spitzenwertbegrenzungstransistor (T) des Bipolartyps und einen Ladungstransistor (M) des MOS-Typs enthält, wobei der Emitter des Spitzenwertbegrenzungstransistors und das Gate des Ladungstransistors an den Eingang (12) angeschlossen sind, die Basis des Spitzenwertbegrenzungstransistors an den Drain des Ladungstransistors angeschlossen ist und der Kollektor des Spitzenwertbegrenzungstransistors an ein auf den Spitzenwertbegrenzungspegel bezogenes Potential angeschlossen ist und die Source des Ladungstransistors an ein zweites Versorgungspotential angeschlossen ist.

2. Schaltung nach Anspruch 1, dadurch gekennzeichnet, daß der Spitzenwertbegrenzungstransistor (T) vom Typ npn ist und der Ladungstransistor (M) vom Typ PMOS ist.

3. Schaltung nach Anspruch 1, dadurch gekennzeichnet, daß der Spitzenwertbegrenzungstransistor (T) vom Typ pnp und der Ladungstransistor (M) vom Typ NMOS ist.

## Claims

1. An amplitude limitation circuit (Cl) for an integrated circuit, shunt-connected at the input (12) of a receiving device (R1), characterised in that it comprises a bipolar-type amplitude limitation transistor (T) and an MOS-type load transistor (M), with the emitter of the amplitude limitation transistor and the gate of the load transistor connected to said input (12), the base of the amplitude limitation transistor connected to the drain of the load transistor, the collector of the amplitude limitation transistor connected to the potential relating to the amplitude limitation level and the source of the load transistor connected to a second supply potential.

2. A circuit according to Claim 1, characterised in that the amplitude limitation transistor (T) is of the npn type and the load transistor (M) is of the PMOS type.

3. A circuit according to Claim 1, characterised in that the amplitude limitation transistor (T) is of the pnp type and the load transistor (M) is of the NMOS type.
